(19) **Europäisches Patentamt / European Patent Office / Office européen des brevets**

(11) **EP 3 028 193 B1**

(12) # FASCICULE DE BREVET EUROPEEN

(45) Date de publication et mention
de la délivrance du brevet:
**17.04.2019 Bulletin 2019/16**

(21) Numéro de dépôt: **14750589.5**

(22) Date de dépôt: **28.07.2014**

(51) Int Cl.:
**G06F 17/50** (2006.01)     **B64C 11/18** (2006.01)
**F01D 5/14** (2006.01)      **F04D 27/00** (2006.01)
**F04D 29/32** (2006.01)     **B64D 27/00** (2006.01)

(86) Numéro de dépôt international:
**PCT/FR2014/051953**

(87) Numéro de publication internationale:
**WO 2015/015107 (05.02.2015 Gazette 2015/05)**

(54) **PROCÉDÉ DE MODÉLISATION D'UNE PALE D'UNE HÉLICE NON-CARÉNÉE**

VERFAHREN ZUR MODELLIERUNG EINES NICHT STROMLINIENFÖRMIGEN
PROPELLERBLATTS

METHOD FOR MODELLING AN OPEN ROTOR BLADE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.07.2013 FR 1357449**

(43) Date de publication de la demande:
**08.06.2016 Bulletin 2016/23**

(73) Titulaire: **Safran Aircraft Engines
75015 Paris (FR)**

(72) Inventeurs:
• **VERBRUGGE, Cyril**
  **F-77550 Moissy Cramayel Cedex (FR)**
• **VLASTUIN, Jonathan**
  **F-77550 Moissy Cramayel Cedex (FR)**
• **DEJEU, Clément**
  **F-77550 Moissy Cramayel Cedex (FR)**
• **LOUET, Anthony**
  **F-77550 Moissy Cramayel Cedex (FR)**

(74) Mandataire: **Regimbeau
87 rue de Sèze
69477 Lyon Cedex 06 (FR)**

(56) Documents cités:
• B.G. MARINUS ET AL: "Aerodynamic study of a 'humpy' propeller", INTERNATIONAL JOURNAL OF ENGINEERING SYSTEMS MODELLING AND SIMULATION, vol. 4, no. 1/2, 2012, pages 27-35, XP055116379, ISSN: 1755-9758, DOI: 10.1504/IJESMS.2012.044841
• B G MARINUS: "INFLUENCE OF PARAMETERIZATION AND OPTIMIZATION METHOD ON THE OPTIMUM AIRFOIL", 27TH CONGRESS OF THE INTERNATIONAL COUNCIL OF THE AERONAUTICAL SCIENCES - ICAS 2010, 24 septembre 2010 (2010-09-24), pages 1-14, XP055117598, ISBN: 978-0-95-653330-2
• B G MARINUS ET AL: "Aeroacoustic and Aerodynamic Optimization of Aircraft Propeller Blades", 16TH AIAA/CEAS AEROACOUSTICS CONFERENCE - STOCKHOLM (SWEDEN), 8 juin 2010 (2010-06-08), pages 1-17, XP055116433, DOI: doi:10.2514/6.2010-3850
• SIMON J READ AND THOMAS P HYNES: "Effect of a Winglet on Open Rotor Aerodynamics and Tip Vortex Interaction", 49TH AIAA/ASME/SAE/ASEE JOINT PROPULSION CONFERENCE), 15-17/07/2013; SAN JOSE, CALIFORNIA, USA, AMERICAN INSTITUTE OF AERONAUTICS AND ASTRONAUTICS, USA, vol. 1, 17 juillet 2013 (2013-07-17), pages 289-312, XP008169043, DOI: 10.2514/6.2013-3629 ISBN: 978-1-62748-897-6

• C. DE MAESSCHALCK ET AL: "Blade Tip Shape Optimization for Enhanced Turbine Aerothermal Performance", ASME TURBO EXPO 2013: TURBINE TECHNICAL CONFERENCE AND EXPOSITION VOLUME 3C: HEAT TRANSFER, vol. Paper No. GT2013-94754, 7 June 2013 (2013-06-07), XP055492283, DOI: 10.1115/GT2013-94754 ISBN: 978-0-7918-5516-4

**Description**

DOMAINE TECHNIQUE GENERAL

La présente invention concerne la conception assistée par ordinateur.

Plus précisément, elle concerne un procédé de modélisation d'une pale d'hélice.

ETAT DE L'ART

Les moteurs à soufflantes « non carénées » (ou turbopropulseurs de type « Propfan » ou « Open rotor ») sont un type de turbomachine dont la soufflante est fixée en dehors du carter, contrairement aux turboréacteurs classiques (de type « Turbofan ») dans lesquels la soufflante est carénée.

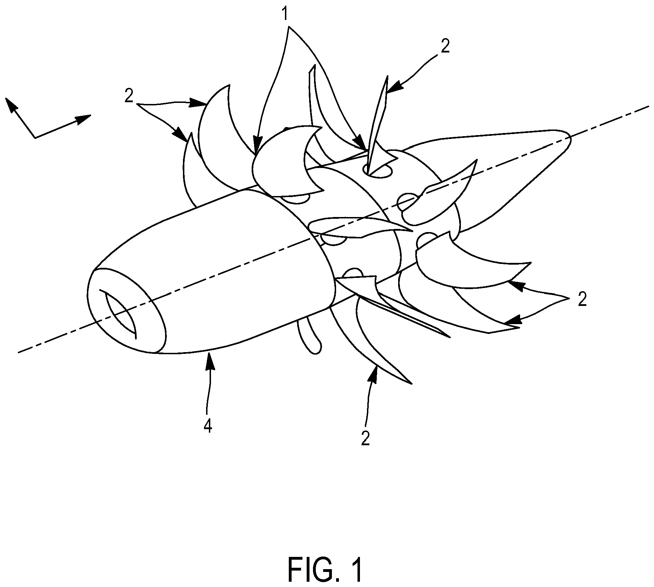

On connait notamment le « Contra-Rotating Open Rotor » (CROR, rotor ouvert contra-rotatif), représenté par la **figure 1**, qui est équipé de deux hélices tournant dans des sens opposés. Il présente un grand intérêt de par son rendement propulsif particulièrement élevé.

Le but de ce type de moteur est ainsi de garder la vitesse et les performances d'un turboréacteur en conservant une consommation de carburant similaire à celle d'un turbopropulseur. Le fait que la soufflante ne soit plus carénée permet en effet d'augmenter le diamètre et le débit d'air utile à la poussée.

Toutefois, l'absence de carénage entraîne des problèmes de respect de spécification. Notamment en terme d'acoustique puisque ce type de moteur génère plus de bruit qu'un moteur classique. En effet, la production de traction sur chaque pale d'hélice relève de la présence d'une répartition de circulation sur l'envergure des hélices. Et cette circulation s'échappe naturellement en tête de pale (au lieu d'être canalisée par le carter), créant un tourbillon dit « marginal ».

L'interaction de ce tourbillon marginal de tête de pale amont sur les surfaces en rotation de l'hélice aval pose un réel défi en termes d'acoustique, dans la mesure où le fort bruit généré n'est bloqué par aucun carter.

Les normes actuelles imposent un seuil maximum de bruit en zones proche sol, c'est-à-dire lors du décollage et de l'approche, que les géométries actuelles ne permettent pas d'atteindre.

Il serait souhaitable d'améliorer ces géométries, en particulier au niveau des têtes de pâles, de sorte à diminuer le bruit généré sans impacter de manière importante ni l'efficacité du moteur, ni sa consommation.

On connait pour cela de nombreux outils informatiques de modélisation de pales ou d'autres pièces aéronautiques, qui permettent d'aider à concevoir ces pièces en optimisant de façon automatisée certaines de leurs caractéristiques. Le principe est de déterminer un optimum géométrique aéromécanique de lois de la pale, en d'autres termes d'une ou plusieurs courbes décrivant la valeur d'une grandeur physique (telle que le rendement, l'élévation de pression, la capacité de débit ou la marge au pompage) le long d'une coupe ou d'une hauteur de la pale, dans un environnement donné, par l'exécution d'un grand nombre de calculs de simulation.

Toutefois, on utilise aujourd'hui les mêmes procédés pour dessiner les soufflantes carénées que les hélices non carénées, c'est-à-dire la modélisation de profils 2D qui sont par la suite enroulés sur des lignes de courant (en respect des angles du profil) et empilés selon une loi d'empilage choisie et optimisée.

De telles solutions d'avèrent adaptées pour de nombreuses grandeurs physiques des hélices non carénées, mais il reste très difficile d'obtenir une amélioration sensible des niveaux de bruit.

Alternativement, il serait possible d'utiliser des algorithmes de déformation de maillage. De telles méthodes restent envisagées car elles offrent beaucoup d'avantages en termes de propreté de surface et facilité de dessin. Elles demandent cependant à ce jour beaucoup de travail de développement avant d'être utilisables en conception industrielle.

Il serait donc souhaitable de trouver une méthode innovante de modélisation d'une hélice non carénée qui permettent une amélioration sensible de leurs performances aéro-acoustiques tout en étant économe en termes d'utilisation de ressources informatiques.

Le document "Aerodynamic study of a 'humpy' propeller", International Journal of Engineering Systems Modelling and Simulation, vol. 4, no. 1/2, pages 27-35, 2012 (B. G. Marinus et al) concerne une étude aérodynamique d'une pale d'une hélice non-carénée présentant un déport. Le document "Blade Tip Shape Optimization for Enhanced Turbine Aerothermal Performance", ASME Turbo Expo 2013: Turbine Technical Conférence and Exposition, Volume 3C: Heat Transfer. Paper No. GT2013-94754, 3-7 juin 2013 (C. De Maesschalck et al) concerne l'optimisation d'une pale d'une hélice utilisant des courbes de Bézier.

PRESENTATION DE L'INVENTION

La présente invention propose selon un premier aspect un procédé mis en oeuvre par ordinateur selon la revendication 1.

Selon d'autres caractéristiques avantageuses et non limitatives :

- l'ordonnée $y_K$ du deuxième point de contrôle extrémal est donnée par $y_K = d_{max} * \left(\frac{h-h_0}{1-h_0}\right)^2$ ;

- l'abscisse $x_i$ de l'au moins un point de contrôle intermédiaire est proportionnelle à $x_{rel} = 1 - \left(\frac{h-h_0}{1-h_0}\right)^2$ ;

- $K \geq 4$, le ou les i$^{\text{èmes}}$, $i \in [\![2, K-2]\!]$, points de contrôle intermédiaires étant des points mobiles dont l'abscisse est fonction de la hauteur de ladite coupe dans la pale, le $K$-$2^{ième}$ point de contrôle intermédiaire étant fixe ;

- l'abscisse $x_i$ des $K$-$3$ points mobiles de contrôle intermédiaires est donnée par

$$x_{i \in [\![2, K-2]\!]} = x_{K-1} * \frac{i-1}{K-3} * x_{rel} \quad \text{avec} \quad x_{K-1}$$

l'abscisse du point fixe de contrôle intermédiaire ($PCU_{K-1}$) ;

- $x_{K-1}$ = 0.75 ;
- $K$ = 7, de sorte à avoir 4 points mobiles de contrôle intermédiaire ;
- l'ordonnée du premier point de contrôle extrémal et de chaque point de contrôle intermédiaire est égale à zéro ;
- la dérivée de la courbe de Bézier au niveau du premier point de contrôle extrémal est nulle ;
- une pluralité de courbes de Bézier correspondant à des coupes à des hauteurs différentes dans la pale est paramétrisée à l'étape (a).

Selon un deuxième aspect, l'invention concerne un procédé de fabrication d'une pale d'une hélice noncarénée, la pale présentant un déport, le procédé comprenant des étapes de :

- Mise en oeuvre du procédé selon le premier aspect de sorte à modéliser au moins une partie de la pale ;
- Fabrication de ladite pale conformément à la modélisation de l'au moins une partie de la pale obtenue.

Selon un troisième aspect, l'invention concerne un équipement selon la revendication 10.

Selon un quatrième et un cinquième aspect, l'invention concerne respectivement un produit programme d'ordinateur comprenant des instructions de code pour l'exécution d'un procédé selon le premier aspect de l'invention de modélisation d'au moins une partie d'une pale d'une hélice non carénée ; et un moyen de stockage lisible par un équipement informatique sur lequel un produit programme d'ordinateur comprend des instructions de code pour l'exécution d'un procédé selon le premier aspect de l'invention.

PRESENTATION DES FIGURES

D'autres caractéristiques et avantages de la présente invention apparaîtront à la lecture de la description qui va suivre d'un mode de réalisation préférentiel. Cette description sera donnée en référence aux dessins annexés dans lesquels :

- la figure 1 précédemment décrite représente un exemple de rotor ouvert contra-rotatif sur les aubes duquel le procédé selon l'invention est mis en oeuvre ;

- les figures 2a-2b sont deux vues de l'extrémité d'une pale d'une hélice non carénée d'un tel rotor ;
- la figure 3 représente un système pour la mise en oeuvre du procédé selon l'invention ;
- la figure 4 illustre la mise en oeuvre du procédé sur une pale d'une hélice non carénée ;
- la figure 5 est un exemple de graphe représentant des courbes de déformation de la pale obtenues grâce à un mode de réalisation du procédé selon l'invention ;
- les figures 6a-6b permettent de comparer les performances aéro-acoustiques d'une pale connue et d'une pale modélisée grâce au procédé selon l'invention.

DESCRIPTION DETAILLEE

*Déport de pale*

Sur la figure 1, l'open-rotor représenté comprend une turbine 4, et deux hélices 1 non-carénées. Ces hélices 1 sont, dans cet exemple, contrarotatives. Chaque hélice 1 présente une pluralité de pales 2 s'étendant radialement depuis le carter du rotor.

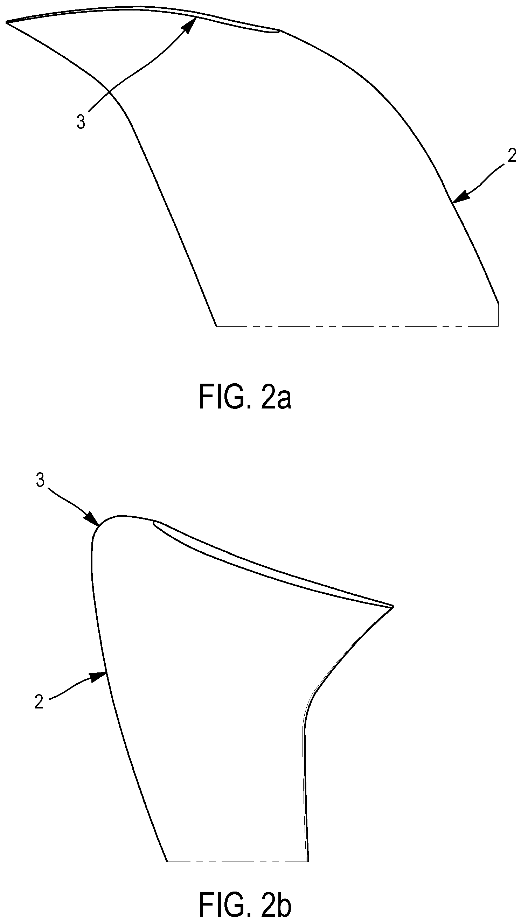

Les **figures 2a et 2b** représentent un détail de la tête d'une pale 2. Cette tête est équipée d'un déport 3, en d'autres termes système de type dit « Winglet ». Il s'agit d'une forte courbure, qui prend parfois jusqu'à la forme d'une ailette orthogonale (cas des Winglets en bout d'aile). L'intérêt d'un tel système est de dessiner en tête de pale 2 des profils déchargés (Cz=0) voire chargés négativement en inversant l'extrados et l'intrados.

On peut espérer grâce à un tel déport 3 une meilleure dissipation des tourbillons marginaux générés en bout de pale 2. Toutefois, il n'a jusqu'à présent pas été possible d'obtenir de géométrie de tête de pale 2 qui y parvienne suffisamment pour réduire les nuisances sonores.

Le présent procédé est conçu pour la modélisation spécifique d'au moins une partie d'une pale 2 (en particulier sa tête) d'une hélice non carénée 1, la partie de pale 2 présentant un déport tangentiel 3. L'idée est de pour cela définir le déport 3 comme une déformation du « squelette » de la pale 2 par rapport à un plan de référence, ce avantageusement à partir de certains paramètres très spécifiques qui seront décrits plus loin.

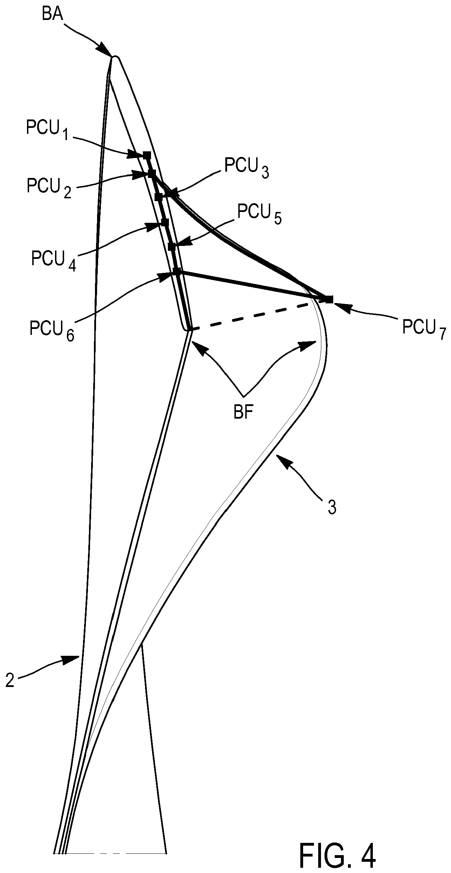

Le squelette est, dans une coupe (c'est-à-dire une section transversale) de la pale 2, une ligne médiane qui s'étend d'un bord d'attaque BA vers un bord de fuite BF. La **figure 4** représente une même pale 2 dans deux configurations : initiale (c'est-à-dire sans déport 3, le squelette prend la forme d'une ligne droite) et déformée (c'est-à-dire avec un déplacement du bord de fuite de sorte à donne une forme incurvée au squelette caractérisant le déport 3). Cette figure 4 sera décrite plus en détail plus loin. Le squelette ne doit pas être confondu avec la corde, qui relie également les bords d'attaque et de fuite dans une coupe, mais en passant par l'enveloppe de la pale 2.

Orthogonalement à une coupe, on trouve la « hauteur » de la pale 2, c'est-à-dire la position selon un axe longitudinal. Chaque coupe de la pale 2 est à une hauteur donnée dans la pale 2.

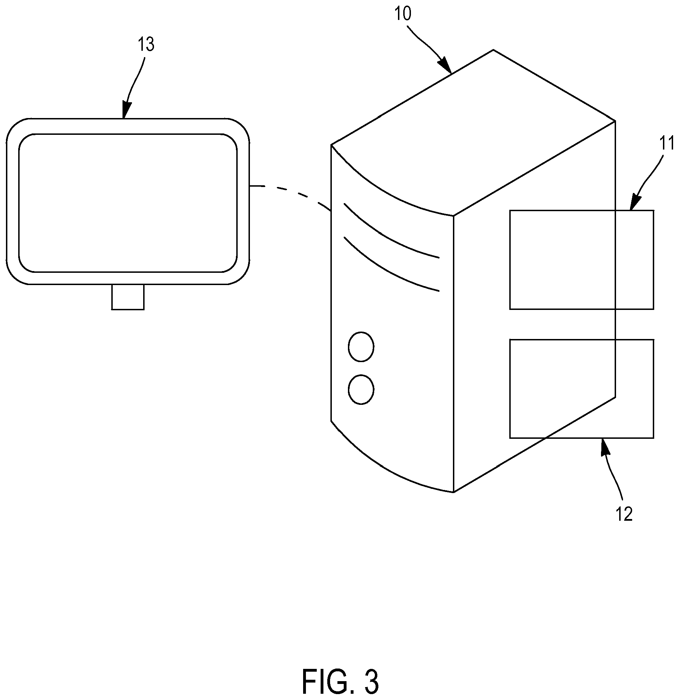

La partie de pale 2 est modélisée, lors de sa conception, via un équipement informatique 10 du type de celui représenté sur la **figure 3.** Il comprend des moyens de traitement de données 11 (un ou plusieurs processeur), des moyens de stockage de données 12 (par exemple un ou plusieurs disques dur), des moyens d'interface 13 (composés de moyens de saisie tels qu'un clavier et une souris ou une interface tactile, et de moyens de restitution tels qu'un écran pour affichage des résultats). De façon avantageuse, l'équipement 10 est un supercalculateur, mais on comprendra qu'une mise en oeuvre sur des plateformes variées est tout à fait possible.

Même si la dissipation des tourbillons est le critère principal choisi pour être optimisé lors de la modélisation de la pale, on comprendra que d'autres critères peuvent être choisis. A titre d'exemple, on pourra tenter de maximiser des propriétés mécaniques telles que la résistance aux contraintes mécaniques, les réponses fréquentielles de l'aube, les déplacements de la pale, des propriétés aérodynamiques telles que le rendement, l'élévation de pression, la capacité de débit ou la marge au pompage, etc.

*Paramétrisation*

Il est nécessaire de paramétriser la loi de déformation squelette que l'on cherche à optimiser, c'est-à-dire d'en faire une fonction de N paramètres d'entrée. L'optimisation consiste alors à faire varier (en général aléatoirement) ces différents paramètres sous contrainte, jusqu'à déterminer leurs valeurs optimales pour le critère prédéterminé de dissipation des tourbillons. Une courbe « lissée » est ensuite obtenue par interpolation à partir des points de passage déterminés.

Le nombre de calculs nécessaires est alors directement lié (linéairement voire exponentiellement) au nombre de paramètres d'entrée du problème.

De nombreuses méthodes de paramétrisation d'une loi existent, et on peut en particulier distinguer deux grandes catégories :

- Modèle discret : la loi est définie par la position d'une pluralité de points (en pratique 5 à 10 pour une loi sur la hauteur, et 50 à 200 pour une coupe), déplacés un à un lors de l'optimisation ;
- Modèle paramétrique : la loi est définie via des courbes mathématiques connues dans la littérature, telles que les courbes de Bézier ou les courbes NURBS (B-splines rationnelles non uniformes).

Il est souhaitable d'utiliser un grand nombre de paramètres pour améliorer d'autant la qualité d'une loi (c'est un enjeu majeur pour les conceptions de pales), mais une telle démarche est rapidement limitée par la capacité et les ressources des processeurs actuels.

Même en utilisant des supercalculateurs onéreux, le temps nécessaire à la modélisation d'une seule loi est conséquent.

Autre problème, on constate qu'en présence d'un grand nombre de paramètres des problèmes apparaissent : les lois déterminées présentent en effet un trop grand nombre de points de passage à respecter, et les premières courbes obtenues sont anormalement « ondulées » (c'est ce que l'on appelle le phénomène de Runge) et inexploitables en l'état. Il faut les retravailler jusqu'à ce qu'elles soient suffisamment lisses, ce qui augmente encore le délai nécessaire à l'obtention des résultats

Comme l'on va voir, le présent procédé permet une qualité de modélisation excellente d'une tête de pale 2 qui permet avec un nombre étonnamment réduit de paramètres d'obtenir une amélioration sensible de la dissipation des tourbillons marginaux (et donc du niveau de bruit)

Dans une étape (a), mise en oeuvre par les moyens de traitement de données 11 sous contrôle d'un opérateur, est paramétrée une courbe représentant la valeur d'une déformation de la pale 2 (caractérisant comme expliqué le déport 3) en fonction d'une position le long d'une coupe de la pale 2 de l'hélice non-carénée 1, à une hauteur donnée dans la pale 2. Par « coupe », on entend également « partie de coupe », c'est-à-dire tout ou partie de l'espace s'étendant du bord d'attaque BA au bord de fuite BF.

La position le long de la courbe est de façon préférée exprimée en fonction de la longueur de squelette (en abscisse), et plus précisément la longueur de squelette « normalisée », c'est-à-dire exprimée entre 0 et 1 lorsque l'on traverse la pale 2 d'un bord à un autre. Cela correspond en d'autres termes à la coordonnée x qu'aurait un point du squelette dans un repère orthonormé dans lequel le point BA aurait (0,0) comme coordonnées, et le point BF (1,0). Par exemple, un point de la coupe associé à une longueur de squelette normalisée de « 0,5 » est sur la médiatrice du squelette. On note que comme la courbe peut s'étendre sur une partie seulement (continue) de la coupe de la pale 2, la fonction associée est définie sur un sous-intervalle de [0, 1].

On comprendra toutefois que l'invention n'est aucunement limitée à l'expression d'une courbe représentant la valeur d'une déformation en fonction d'une longueur de squelette, et que d'autres repères sont possibles (par exemple longueur de corde).

Cette courbe représentant la valeur d'une déformation doit être comprise comme la modélisation de la loi de déformation.

C'est une courbe de Bézier. Ces dernières sont des courbes polynomiales paramétriques définies comme combinaisons de *N*+1 polynômes élémentaires dits Polynômes de Bernstein : on définit une courbe de Bézier par l'ensemble de points $\sum_{i=0}^{N} B_i^N(t) \cdot \boldsymbol{P}_i$ , $t \in [0,1]$, les $B_i^N(t) = \binom{N}{i} t^N (1-t)^{N-i}$ étant les *N+1* polynômes de Bernstein de degré *N*.

Les points {P$_0$, P$_1$...P$_N$} sont appelés points de contrôle « implicites » de la courbe et constituent les variables grâce auxquelles une loi d'une pale peut être modélisée par une courbe de Bézier.

Ces points sont appelés « implicites » car une courbe de Bézier peut être vue comme l'ensemble des barycentres des *N+1* points de contrôle pondérés d'un poids égal à la valeur du polynôme de Bernstein associé à chaque point de contrôle. En d'autres termes, ces points agissent comme des poids localisés attirants la courbe généralement sans qu'elle n'y passe (hormis le premier et le dernier, correspondant respectivement à *t=0* et *t=1,* et certains cas d'alignement de points).

De façon générale, dans les techniques de modélisation connues d'une loi utilisant une courbe de Bézier, les points de contrôle extrémaux P$_0$ et P$_N$ de la courbe utilisée sont fixés (ils définissent l'étendue de la partie d'une pièce sur laquelle la modélisation va être mise en oeuvre), mais les autres points {P$_1$...P$_{N-1}$} présentent des coordonnées mobiles constituant les paramètres d'entrée pour l'algorithme d'optimisation.

Dans le présent procédé, comme dans l'art antérieur la courbe est définie grâce à ses *K* points de contrôle, $K \geq 3$. Deux points de contrôle utilisateur extrémaux PCU$_1$ et PCU$_K$ (i = 1 et i = *K*) définissent l'étendue de la partie de la pièce (i.e. le domaine de définition de la courbe). La courbe de Bézier utilise en outre au moins un point de contrôle utilisateur intermédiaire PCU$_i$, $i \in [\![2, K-1]\!]$ disposé entre ces deux points extrémaux PCU$_1$ et PCU$_K$.

Toutefois, le deuxième point extrémal PCU$_K$ est ici le principal point mobile. En particulier, l'abscisse d'au moins un point de contrôle intermédiaire PCU$_i$ (voire comme on le verra plus tard, tous sauf un) et l'ordonnée du deuxième point extrémal PCU$_K$ sont fonction de ladite hauteur de la coupe dans la pale 2 et d'au moins un paramètre de déformation. En d'autres termes, la paramétrisation est mise en oeuvre selon ce paramètre de déformation et la hauteur de la coupe dans la pale 2.

L'idée est modifier le squelette en tête de pale 2 de façon coordonnée sur une pluralité de coupes (la déformation se « propage ») continûment en fonction de leur hauteur dans la pale 2, et le ou les paramètres de déformation. En d'autres termes, une pluralité de courbes de Bézier correspondant à des coupes à des hauteurs différentes dans la pale 2 est paramétrisée à l'étape (a)

*Paramètres de déformation et points de contrôle utilisateur*

Les paramètres de déformation sont au nombre de deux :

- une hauteur relative de début de déformation *h$_0$* ; et
- un déport maximum *d$_{max}$* à l'extrémité de la pale 2,

*h$_0$* est une hauteur relative, c'est-à-dire « normalisée », en d'autres termes exprimée entre 0 et 1 lorsque l'on traverse la pale 2 de la base (jonction avec le disque de l'hélice 1) à l'extrémité de la tête. Il s'agit d'une hauteur de début de déformation, c'est-à-dire que le déport 3 existe dans l'intervalle [*h$_0$*, 1]. Chaque courbe de Bézier paramétrisée est ainsi associée à une hauteur relative *h* de coupe dans la pale 2, *h* ∈ [*h$_0$*, 1] (puisque pour *h* ∈ [0, *h$_0$*] il n'y a pas de déformation).

Le déport maximum correspond à la valeur maximum de la déformation sur l'ensemble du déport 3, atteinte à l'extrémité de la pale 2 au niveau du bord de fuite BF (comme l'on voit sur la figure 4, ce dernier se déplace).

Ces deux paramètres de déformation permettent à eux seuls de paramétrer (avec la hauteur *h*) tous les points de contrôle utilisateur définissant une courbe de Béziers de modélisation.

Pour cela on utilise un coefficient $\left(\frac{h-h_0}{1-h_0}\right)^2$ qui varie quadratiquement entre 0 et 1 lorsque *h* parcourt l'intervalle [*h$_0$*, 1].

L'ordonnée *y$_K$* du deuxième point de contrôle extrémal PCU$_K$ est donnée par $y_K = d_{max} * \left(\frac{h-h_0}{1-h_0}\right)^2$. *y$_K$* L'abscisse *x$_i$* du ou des points de contrôle intermédiaire PCU$_i$ est quant à elle proportionnelle à $x_{rel} = 1 - \left(\frac{h-h_0}{1-h_0}\right)^2$.

Ce point de contrôle intermédiaire PCU$_i$ est un point « mobile » dans la mesure où ses coordonnées dépendent de la hauteur de la coupe. Si *K* ≥ 4 (au moins 4 points de contrôle dont deux intermédiaires), il est possible de prévoir un point de contrôle intermédiaire « fixe », le *K-2$^{ième}$* point de contrôle intermédiaire PCU$_{K-1}$ (l'avant-dernier point de contrôle).

Le ou les i$^{èmes}$ ( $i \in [\![2, K-2]\!]$ ) points de contrôle intermédiaires PCU$_i$ sont donc des points mobiles dont l'abscisse est fonction de la hauteur de ladite coupe dans la pale 2 (comme expliqué proportionnellement à $x_{rel} = 1 - \left(\frac{h-h_0}{1-h_0}\right)^2$).

Comme l'on voit sur la figure 4 précédemment introduite, l'ordonnée *y$_i$*, $i \in [\![1, K-1]\!]$ du premier point de contrôle extrémal PCU$_1$ et de chaque point de contrôle intermédiaire PCU$_i$ est avantageusement choisie fixe et égale à zéro. En d'autres termes, ces *K-1* premiers points de contrôle sont alignés et sur le squelette initial. Seul le deuxième point de contrôle extrémal $PCU_K$ s'en écarte.

Et comme expliqué précédemment, la courbe de Bézier ne passe pas par les points de contrôle intermédiaires $PCU_i$. Cet alignement ne crée donc aucun de point anguleux pour la courbe de Béziers mais au contraire contrôle la progressivité de sa courbure. A titre de condition supplémentaire, la dérivée de la courbe de Bézier est contrainte comme nulle au niveau du premier point de contrôle extrémal $PCU_1$, puisque les deux premiers points de contrôle ont une même ordonnée égale à zéro.

Les points de contrôle intermédiaires mobiles $PCU_i$, $i \in [\![2, K-2]\!]$ présentent quant à eux une abscisse variable telle qu'ils se rapprochent du premier point de contrôle extrémal $PCU_1$ lorsque la hauteur augmente, en d'autres termes lorsque l'on s'approche du haut de la pale 2. Ainsi, plus on monte dans la pale 2, plus le poids des points de contrôle intermédiaire est reporté vers le bord d'attaque BA, creusant d'autant la courbure de la courbe de Bézier, et augmentant la part du squelette qui est déformée (à la base du déport 3, seule une petite zone au niveau du bord de fuite BF est incurvée, alors que le déport 3 gagne toute la largeur de pale 2 à son sommet).

Dans la mesure où le dernier point de contrôle intermédiaire $PCU_{K-1}$ est fixe, cela permet de contrôler indépendamment la cambrure finale du déport. L'abscisse de ce point peut donc soit être un paramètre supplémentaire, soit être fixée, par exemple à $x_{K-1} = 0.75$.

Les abscisses des points de contrôle intermédiaire mobiles sont quant à elles définies se sorte à ce que ces derniers présentent des écarts réguliers, et fonction de la position du point de contrôle intermédiaire fixe $PCU_{K-1}$.

En particulier, lorsque $h=h_0$ (base du déport 3) le dernier point de contrôle intermédiaire mobile est confondu avec le point de contrôle intermédiaire fixe, et lorsque $h=1$ (extrémité de la pale 2), $x_{rel}=0$ et l'ensemble des points de contrôle intermédiaires a pour abscisse 0 (ils sont donc confondus avec le premier point de contrôle extrémal $PCU_1$).

A titre d'exemple, on peut choisir des abscisses $x_i$ des $K-3$ points mobiles de contrôle intermédiaires $PCU_i$

données par $x_{i \in [\![2, K-2]\!]} = x_{K-1} * \dfrac{i-1}{K-3} * x_{rel}$ avec $x_{K-1}$ l'abscisse du point fixe de contrôle intermédiaire fixe $PCU_{K-1}$ évoquée avant.

Ainsi, dans une situation optimale (représentée par la figure 4) avec $K = 7$, de sorte à avoir 4 points mobiles de contrôle intermédiaire (plus le point intermédiaire fixe et les deux points extrémaux), les coordonnées des 7 points sont :

$$PCU_1 \; (0 \; ; \; 0)$$

$$PCU_2 \; (0.75 * 1 * x_{rel} / 4 \; ; \; 0)$$

$$PCU_3 \; (0.75 * 2 * x_{rel} / 4 \; ; \; 0)$$

$$PCU_4 \; (0.75 * 3 * x_{rel} / 4 \; ; \; 0)$$

$$PCU_5 \; (0.75 * 4 * x_{rel} / 4 \; ; \; 0)$$

$$PCU_6 \; (0.75 \; ; \; 0)$$

$$PCU_7 \; \left(1 \; ; \; d_{max} * \left(\frac{h-h_0}{1-h_0}\right)^2\right)$$

*Exemple*

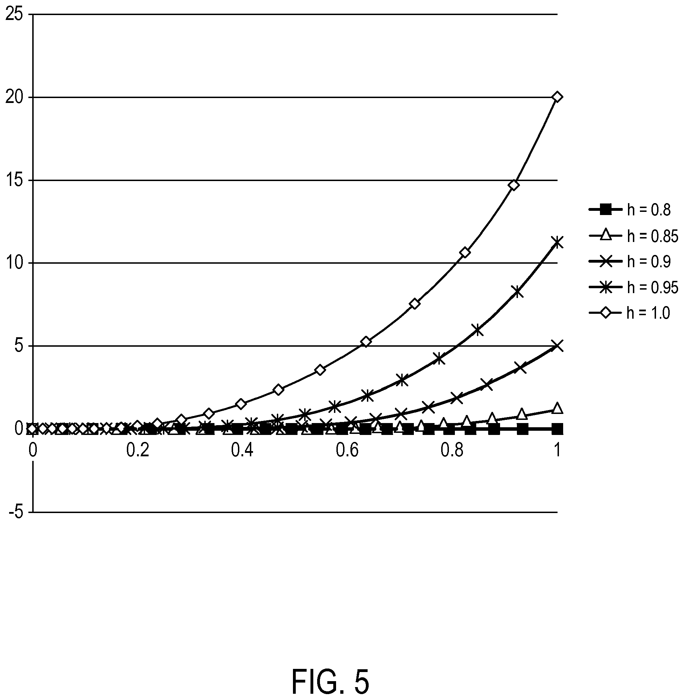

La figure 5 représente les courbes de Bézier obtenues pour 5 hauteurs relatives de coupe comprises entre 0.8 et 1. Les paramètres de déformations associés à cette paramétrisation sont $h_0$ = 0.8 et $d_{max}$ = 20 mm.

On remarque l'augmentation progressive à la fois de l'amplitude du déport 3 et de la part déformée du squelette lorsque la hauteur croit.

*Optimisation et restitution*

Selon une deuxième étape (b), le procédé comprend une étape de détermination par les moyens de traitement de données 11 de valeurs optimisées (et si possible optimales) dudit au moins un paramètre de déformation ($h_0$, $d_{max}$, ainsi qu'éventuellement d'autres tels que $x_{K-1}$). Il s'agit d'une étape d'optimisation.

De nombreuses techniques pour la mise en oeuvre de cette étape sont connues de l'homme du métier, et on pourra par exemple simplement faire varier pseudo-aléatoirement les paramètres choisis variables tout en effectuant des simulations pour déterminer ces valeurs optimisées (c'est-à-dire pour lesquelles le critère choisi, en particulier la diminution des tourbillons marginaux, est maximalisé) des paramètres des points de contrôle $PCU_i$. L'invention n'est toutefois pas limitée à cette possibilité.

Dans une dernière étape (c), les valeurs déterminées du ou des paramètres sont restituées par les moyens d'interface 13 de l'équipement 10 pour exploitation, par exemple par l'affichage de la courbe de modélisation dans laquelle les paramètres sont mis à ces valeurs optimisées.

Alternativement, les moyens d'interface 13 peuvent seulement afficher ces valeurs numériques.

*Tests*

Des tests ont été mis en oeuvre sur des pales 2 ainsi modélisées, de sorte à vérifier la possibilité de pouvoir, pour une pale donnée, augmenter sensiblement la dissipation des tourbillons marginaux.

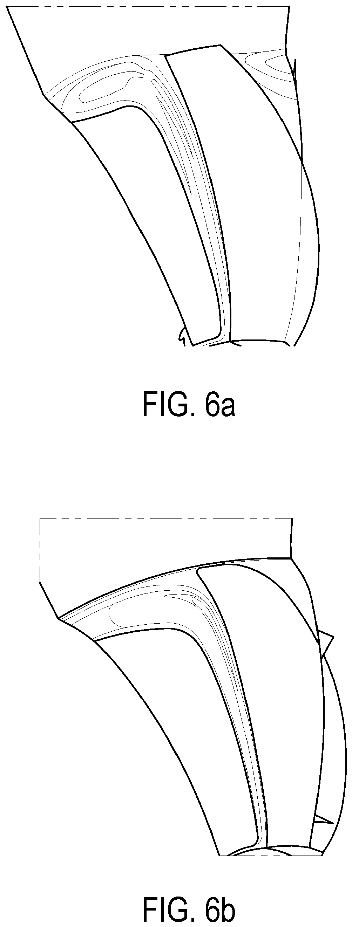

Les **figures 6a et 6b** représentent, respectivement pour une pale classique et pour une pale 2 dont le déport 3 a été optimisé grâce au présent procédé, la vorticité (en d'autres termes l'intensité du tourbillon marginal) en aval de l'hélice non-carénée 1 amont de l'open-rotor de la figure 1.

On constate une diminution de l'intensité de l'ordre de 30% à 40% du maximum de vorticité. On remarque aussi que l'amorce du tourbillon se fait à un rayon légèrement plus bas pour la nouvelle pale 2.

La seule optimisation du déport tangentiel 3 montre donc clairement une modification importante de la physique tourbillonnaire de tête de pale d'hélice, aussi bien en haute vitesse (modification de la trajectoire, centrifugation), qu'en basse vitesse (réduction importante de l'intensité tourbillonnaire et amorce décalée en envergure).

*Procédé de fabrication et hélice*

Une fois sa tête modélisée, la pale 2 peut être fabriquée. Est ainsi proposé un procédé de fabrication d'une pale 2 d'une hélice non-carénée 1, la pale 2 présentant un déport 3, le procédé comprenant des étapes de :

- Mise en oeuvre du procédé selon le premier aspect de sorte à modéliser au moins une partie de la pale ;
- Fabrication de ladite pale 2 conformément à la modélisation de l'au moins une partie de la pale 2 obtenue.

Un hélice non-carénée 1 comprenant une pluralité de pales 2 ainsi produites peut être obtenue. Chacune de ses pales présente donc le déport 3 permettant l'amélioration de la dissipation des tourbillons marginaux, et ainsi la réduction des niveaux de bruits, sans pour autant diminuer ses performances.

*Equipement*

L'équipement informatique 10 (représenté sur la figure 3) pour la mise en oeuvre du procédé selon la revendication 1 comprend des moyens de traitement de données 11 configurés pour mettre en oeuvre :

- Un module de paramétrisation d'au moins une courbe de Bézier représentant une déformation de ladite pale 2 caractérisant le déport 3, en fonction d'une position le long d'une coupe à une hauteur donnée dans la pale 2, le module définissant la courbe par :

a. Un premier et un deuxième point de contrôle extrémaux $PCU_1$, $PCU_K$ définissant l'étendue de ladite coupe de la pale 2 ;

b. Au moins un point de contrôle intermédiaire $PCU_i$, $i \in [\![2, K-1]\!]$ disposé entre les points extrémaux $PCU_1$, $PCU_K$, la paramétrisation étant mise en oeuvre selon au moins un paramètre de déformation et ladite hauteur de la coupe dans la pale 2, en fonction desquels l'abscisse dudit au moins un point de contrôle intermédiaire $PCU_i$ et l'ordonnée du deuxième point extrémal $PCU_K$ sont exprimées, les paramètres de déformation étant une hauteur relative de début de déformation $h_0$ et un déport maximum *dmax* à l'extrémité de la pale, l'au moins une courbe de Bézier paramétrisée étant associée à une hauteur relative h de coupe dans la pale, $h \in [h_0, 1]$ ;

- Un module de détermination de valeurs optimisées des paramètres de déformation pour lesquelles l'intensité d'un tourbillon marginal généré par la pale est minimale ;
- Un module de restitution sur une interface 13 dudit équipement 10 des valeurs déterminées.

*Produit programme d'ordinateur*

Selon d'autres aspects, l'invention concerne un produit programme d'ordinateur comprenant des instructions de code pour l'exécution (sur des moyens de traitement de donnés 11, en particulier ceux de l'équipement 10) d'un procédé selon le premier aspect de l'invention de modélisation d'au moins une partie d'une pale 2 d'une hélice non-carénée 1, ainsi que des moyens de stockage lisibles par un équipement informatique (par exemple une mémoire 12 de cet équipement 10) sur lequel on trouve ce produit programme d'ordinateur.

**Revendications**

1. Procédé mis en oeuvre par ordinateur de détermination de valeurs optimisées des paramètres de déformation de la modélisation d'au moins une partie d'une pale (2) d'une hélice non carénée (1), la partie de pale (2) présentant un déport tangentiel (3), le procédé comprenant les étapes de :

(a) Paramétrisation d'au moins une courbe de Bézier représentant une déformation de ladite pale (2) caractérisant le déport tangentiel (3), en fonction d'une position le long d'une coupe à une hauteur donnée dans la pale (2), la courbe étant définie par :

a. Un premier et un deuxième point de contrôle extrémaux ($PCU_1$, $PCU_K$) définissant l'étendue de ladite coupe de la pale (2) ;
b. Au moins un point de contrôle intermédiaire ($PCU_i$, $i \in [\![2, K-1]\!]$ ) disposé entre les points extrémaux ($PCU_1$, $PCU_K$),

la paramétrisation étant mise en oeuvre selon au moins un paramètre de déformation et ladite hauteur de la coupe dans la pale (2), en fonction desquels l'abscisse dudit au moins un point de contrôle intermédiaire ($PCU_i$) et l'ordonnée du deuxième point extrémal ($PCU_K$) sont exprimées, les paramètres de déformation étant une hauteur relative de début de déformation $h_0$ et un déport maximum $d_{max}$ à l'extrémité de la pale (2), l'au moins une courbe de Bézier paramétrisée étant associée à une hauteur relative $h$ de coupe dans la pale (2), $h \in [h_0, 1]$ ;
(b) Détermination de valeurs optimisées des paramètres de déformation, pour lesquelles l'intensité d'un tourbillon marginal généré par la pale (2) est minimale ;
(c) Restitution sur une interface (13) dudit équipement (10) des valeurs ainsi déterminées.

**2.** Procédé selon la revendication 1, dans lequel l'ordonnée ($y_K$) du deuxième point de contrôle extrémal ($PCU_K$) est donnée par $y_K = d_{max} * \left(\frac{h-h_0}{1-h_0}\right)^2$.

**3.** Procédé selon l'une des revendication 1 et 2, dans lequel l'abscisse ($x_i$) de l'au moins un point de contrôle intermédiaire ($PCU_i$) est proportionnelle à

$$x_{rel} = 1 - \left(\frac{h-h_0}{1-h_0}\right)^2.$$

**4.** Procédé selon l'une des revendications 1 à 3, dans lequel $K \geq 4$, la ou les $i^{èmes}$ $(i \in [\![2, K-2]\!])$ points de contrôle intermédiaires ($PCU_i$) étant des points mobiles dont l'abscisse est fonction de la hauteur de ladite coupe dans la pale (2), le $K\text{-}2^{ième}$ point de contrôle intermédiaire ($PCU_{K-1}$) étant fixe.

**5.** Procédé selon les revendications 3 et 4 en combinaison, dans lequel l'abscisse *($x_i$)* des *K-3* points mobiles de contrôle intermédiaires ($PCU_i$) est donnée par $x_{i \in [\![2, K-2]\!]} = x_{K-1} * \frac{i-1}{K-3} * x_{rel}$ avec ($x_{K-1}$) l'abscisse du point fixe de contrôle intermédiaire ($PCU_{K-1}$).

**6.** Procédé selon l'une des revendications 4 à 5, dans lequel $K = 7$, de sorte à avoir 4 points mobiles de

contrôle intermédiaire ($PCU_i$).

**7.** Procédé selon l'une des revendications 1 à 6, dans lequel l'ordonnée du premier point de contrôle extrémal ($PCU_1$) et de chaque point de contrôle intermédiaire ($PCU_i$) est égale à zéro.

**8.** Procédé selon l'une des revendications 1 à 7, dans lequel une pluralité de courbes de Bézier correspondant à des coupes à des hauteurs différentes dans la pale (2) est paramétrisée à l'étape (a).

**9.** Procédé de fabrication d'une pale (2) d'une hélice non-carénée (1), la pale (2) présentant un déport (3), le procédé comprenant des étapes de :

- Mise en oeuvre du procédé selon l'une des revendications 1 à 8 de sorte à modéliser au moins une partie de la pale (2) ;
- Fabrication de ladite pale (2) conformément à la modélisation de l'au moins une partie de la pale (2) obtenue.

**10.** Equipement informatique (10) de détermination de valeurs optimisées des paramètres de déformation de la modélisation d'au moins une partie d'une pale (2) d'une hélice non carénée (1), la partie de pale (2) présentant un déport tangentiel (3), comprenant des moyens de traitement de données (11) configurés pour mettre en oeuvre :

- Un module de paramétrisation d'au moins une courbe de Bézier représentant une déformation de ladite pale (2) caractérisant le déport tangentiel (3), en fonction d'une position le long d'une coupe à une hauteur donnée dans la pale (2), le module définissant la courbe par :

a. Un premier et un deuxième point de contrôle extrémaux ($PCU_1$, $PCU_K$) définissant l'étendue de ladite coupe de la pale (2) ;
b. Au moins un point de contrôle intermédiaire ($PCU_i$, $i \in [\![2, K-1]\!]$ ) disposé entre les points extrémaux ($PCU_1$, $PCU_K$),

la paramétrisation étant mise en oeuvre selon au moins un paramètre de déformation et ladite hauteur de la coupe dans la pale (2), en fonction desquels l'abscisse dudit au moins un point de contrôle intermédiaire ($PCU_i$) et l'ordonnée du deuxième point extrémal ($PCU_K$) sont exprimées, les paramètres de déformation étant une hauteur relative de début de déformation $h_0$ et un déport maximum $d_{max}$ à l'extrémité de la pale (2), l'au moins une courbe de Bézier paramétrisée étant associée à une hauteur relative $h$ de coupe dans la pale (2), $h \in [h_0, 1]$ ;

- Un module de détermination de valeurs optimisées des paramètres de déformation, pour lesquelles l'intensité d'un tourbillon marginal généré par la pale (2) est minimale ;

- Un module de restitution sur une interface (13) dudit équipement (10) des valeurs déterminées.

**11.** Produit programme d'ordinateur comprenant des instructions de code pour l'exécution d'un procédé selon l'une des revendications 1 à 8 de modélisation d'au moins une partie d'une pale (2) d'une hélice non carénée (1), lorsque ledit programme est exécuté sur un ordinateur.

**12.** Moyen de stockage lisible par un équipement informatique sur lequel un produit programme d'ordinateur comprend des instructions de code pour l'exécution d'un procédé selon l'une des revendications 1 à 8 de modélisation d'au moins une partie d'une pale (2) d'une hélice non carénée (1).

**Patentansprüche**

**1.** Computerimplementiertes Verfahren zur Bestimmung von optimierten Werten der Verformungsparameter der Modellierung zumindest eines Teils eines Blattes (2) eines nicht stromlinienförmigen Propellers (1), wobei der Teil des Blattes (2) einen tangentialen Versatz (3) aufweist, wobei das Verfahren die folgenden Schritte umfasst:

(a) Parametrisierung zumindest einer Bezierkurve, die eine den tangentialen Versatz (3) kennzeichnende Verformung des Blattes (2) darstellt, in Abhängigkeit von einer Position entlang einem Schnitt in einer gegebenen Höhe im Blatt (2), wobei die Kurve definiert wird durch:

a. einen ersten und einen zweiten Endkontrollpunkt ($PCU_1$, $PCU_K$), die die Ausdehnung des Schnittes des Blattes (2) definieren;
b. mindestens einen Zwischenkontrollpunkt ($PCU_i$, $i \in [\![2, K-1]\!]$ ), der zwischen den Endpunkten ($PCU_1$, $PCU_K$) liegt,

wobei die Parametrisierung gemäß mindestens einem Verformungsparameter und der Höhe des Schnittes im Blatt (2) implementiert wird, in deren Abhängigkeit die Abszisse des zumindest einen Zwischenkontrollpunktes ($PCU_i$) und die Ordinate des zweiten Endpunktes ($PCU_K$) ausgedrückt werden, wobei die Verformungsparameter eine relative Höhe des Verformungsbeginns $h_0$ und ein maximaler Versatz $d_{max}$ am Ende des Blattes (2) sind, wobei die zumindest eine parametrisierte Bezierkurve einer relativen Höhe $h$ des Schnittes in dem Blatt (2), $h \in [h_0, 1]$, zugeordnet wird;

(b) Bestimmung der optimierten Werte der Verformungsparameter, bei denen die Intensität eines durch das Blatt (2) erzeugten Randwirbels minimal ist;

(c) Ausgabe der somit bestimmten Werte an einer Schnittstelle (13) des Geräts (10).

**2.** Verfahren nach Anspruch 1, wobei sich die Ordinate ($y_K$) des zweiten Endkontrollpunktes ($PCU_K$) ergibt aus $y_K = d_{max} * \left(\frac{h - h_0}{1 - h_0}\right)^2$.

**3.** Verfahren nach einem der Ansprüche 1 und 2, wobei die Abszisse ($x_i$) des zumindest einen Zwischenkontrollpunktes ($PCU_i$) proportional ist zu

$x_{rel} = 1 - \left(\frac{h - h_0}{1 - h_0}\right)^2$.

**4.** Verfahren nach einem der Ansprüche 1 bis 3, wobei $K \geq 4$, wobei der oder die i-ten ( ($i \in [\![2, K-2]\!]$ )Zwischenkontrollpunkte ($PCU_i$) bewegliche Punkte sind, deren Abszisse von der Höhe des Schnittes in dem Blatt (2) abhängig ist, wobei der K-2-te Zwischenkontrollpunkt ($PCU_{K-1}$) ein fester Punkt ist.

**5.** Verfahren nach einem der Ansprüche 3 und 4 in Kombination, wobei sich die Abszisse ($x_i$) der K-3 beweglichen Zwischenkontrollpunkte ($PCU_i$) ergibt aus $x_{i \in [\![2, K-2]\!]} = x_{K-1} * \frac{i-1}{K-3} * x_{rel}$, mit ($x_{K-1}$) als Abszisse des festen Zwischenkontrollpunktes ($PCU_{K-1}$).

**6.** Verfahren nach einem der Ansprüche 4 bis 5, wobei K=7, sodass sich 4 bewegliche Zwischenkontrollpunkte ($PCU_i$) ergeben.

**7.** Verfahren nach einem der Ansprüche 1 bis 6, wobei die Ordinate des ersten Endkontrollpunktes ($PCU_1$) und jedes Zwischenkontrollpunktes ($PCU_i$) gleich Null ist.

**8.** Verfahren nach einem der Ansprüche 1 bis 7, wobei eine Vielzahl von Bezierkurven, die den Schnitten in unterschiedlichen Höhen im Blatt (2) entsprechen, in Schritt (a) parametrisiert wird.

**9.** Verfahren zur Herstellung eines Blattes (2) eines nicht stromlinienförmigen Propellers (1), wobei das Blatt (2) einen Versatz (3) aufweist, wobei das Verfahren die folgenden Schritte umfasst:

- Implementierung des Verfahrens nach einem der Ansprüche 1 bis 8, um zumindest einen Teil des Blattes (2) zu modellieren;
- Herstellung des Blattes (2) in Übereinstimmung mit der Modellierung des zumindest einen erzielten Teils des Blattes (2).

10. Computergerät (10) zur Bestimmung von optimierten Werten der Verformungsparameter der Modellierung zumindest eines Teils eines Blattes (2) eines nicht stromlinienförmigen Propellers (1), wobei der Teil des Blattes (2) einen tangentialen Versatz (3) aufweist, mit den folgenden für die Implementierung konfigurierten Datenverarbeitungsmitteln (11):

- ein Modul zur Parametrisierung zumindest einer Bezierkurve, die eine den tangentialen Versatz (3) kennzeichnende Verformung des Blattes (2) darstellt, in Abhängigkeit von einer Position entlang einem Schnitt in einer gegebenen Höhe im Blatt (2), wobei das Modul die Kurve definiert durch:

    a. einen ersten und einen zweiten Endkontrollpunkt ($PCU_1$, $PCU_K$), die die Ausdehnung des Schnittes des Blattes (2) definieren;
    b. mindestens einen Zwischenkontrollpunkt ($PCU_i$, $i \in [\![2, K{-}1]\!]$), der zwischen den Endpunkten ($PCU_1$, $PCU_K$) liegt,

wobei die Parametrisierung gemäß mindestens einem Verformungsparameter und der Höhe des Schnittes im Blatt (2) implementiert wird, in deren Abhängigkeit die Abszisse des zumindest einen Zwischenkontrollpunktes ($PCU_i$) und die Ordinate des zweiten Endpunktes ($PCU_K$) ausgedrückt werden, wobei die Verformungsparameter eine relative Höhe des Verformungsbeginns $h_0$ und ein maximaler Versatz $d_{max}$ am Ende des Blattes (2) sind, wobei die zumindest eine parametrisierte Bezierkurve einer relativen Höhe $h$ des Schnittes in dem Blatt (2), $h \in [h_0, 1]$, zugeordnet wird;
- ein Modul zur Bestimmung der optimierten Werte der Verformungsparameter, bei denen die Intensität eines durch das Blatt (2) erzeugten Randwirbels minimal ist;
- ein Modul zur Ausgabe der bestimmten Werte an einer Schnittstelle (13) des Geräts (10).

11. Computerprogrammprodukt mit Befehlscodes für die Ausführung eines Verfahrens nach einem der Ansprüche 1 bis 8 zur Modellierung zumindest eines Teils eines Blattes (2) eines nicht stromlinienförmigen Propellers (1), wenn das Programm auf einem Computer ausgeführt wird.

12. Von einem Computergerät lesbares Speichermedium, auf dem ein Computerprogrammprodukt Befehlscodes für die Ausführung eines Verfahrens nach einem der Ansprüche 1 bis 8 zur Modellierung zumindest eines Teils eines Blattes (2) eines nicht stromlinienförmigen Propellers (1) umfasst.

## Claims

1. A computer-implemented method for determining optimized values of the deformation parameters of the modeling of at least one portion of a blade (2) of a non-streamlined propeller (1), the blade portion (2) having a tangential offset (3), the method comprising the steps of:

    (a) parameterizing at least one Bezier curve representing a deformation of said blade (2) characterizing the tangential offset (3), depending on a position along a section at a given height in the blade (2), the curve being defined by:

        a. a first and second end control point ($PCU_1$, $PCU_K$) defining the extent of said section of the blade (2);
        b. at least one intermediate control point ($PCU_i$, $i \in [\![2, K{-}1]\!]$) positioned between the end points ($PCU_1$, $PCU_K$),

    the parameterization being performed according to at least one deformation parameter and said height of the section in the blade (2), as a function of which the abscissa of said at least one intermediate control point ($PCU_i$) and the ordinate of the second end point ($PCU_K$) are expressed, the deformation parameters being a relative height of the beginning of the deformation $h_0$ and a maximum offset $d_{max}$ at the end of the blade (2), the at least one parameterized Bezier curve being associated with a relative sectional height $h$ in the blade (2), $h \in [h_0, 1]$ ;
    (b) determining optimized values of the deformation parameters, for which the intensity of a marginal vortex generated by the blade (2) is a minimum;
    (c) outputting to an interface (13) of said piece of equipment (10) the thereby determined values.

2. The method according to claim 1, wherein the ordinate ($y_K$) of the second end control point ($PCU_K$) is given by $y_K = d_{max} * \left(\frac{h - h_0}{1 - h_0}\right)^2$.

3. The method according to one of claims 1 and 2, wherein the abscissa ($x_i$) of the at least one intermediate control point ($PCU_i$) is proportional to

$$x_{rel} = 1 - \left(\frac{h - h_0}{1 - h_0}\right)^2.$$

4. The method according to one of claims 1 to 3, wherein $K \geq 4$, the $i^{ith}$ ( $\left(i \in \llbracket 2, K-2 \rrbracket\right)$ )intermediate control points ($PCU_i$) being movable points for which the abscissa depends on the height of said section in the blade (2), the K-2$^{th}$ intermediate control point ($PCU_{K-1}$) being set.

5. The method according to claims 3 and 4 as a combination, wherein the abscissa ($x_i$) of the K-3 movable intermediate control points ($PCU_i$) is given by

$$x_{i \in \llbracket 2, K-2 \rrbracket} = x_{K-1} * \frac{i-1}{K-3} * x_{rel} \text{ with } (x_{K-1}) \text{ the abscissa of the set intermediate control point } (PCU_{K-1}).$$

6. The method according to one of claims 4 to 5, wherein K = 7, so as to have four movable intermediate control points ($PCU_i$).

7. The method according to one of claims 1 to 6, wherein the ordinate of the first end control point ($PCU_1$) and of each intermediate control point ($PCU_i$) is equal to zero.

8. The method according to one of claims 1 to 7, wherein a plurality of Bezier curves corresponding to sections at different heights in the blade (2) is parameterized in step (a).

9. The method for manufacturing a blade (2) of a non-streamlined propeller (1), the blade (2) having an offset (3), the method comprising steps of:

   - performing the method according to one of claims 1 to 8 so as to model at least one portion of the blade (2);
   - manufacturing said blade (2) according to the modeling of the at least one portion of the obtained blade (2).

10. A piece of computer equipment (10) for determining optimized values of the deformation parameters of the modeling of at least one portion of a blade (2) of a non-streamlined propeller (1), the blade portion (2) having a tangential offset (3), comprising data processing means (11) configured for implementing:

   - a module for parameterizing at least one Bezier curve representing a deformation of said blade (2) characterizing the tangential offset (3), depending on a position along a section at a given height in the blade (2), the module defining the curve with:

   a. a first and a second end control point ($PCU_1$, $PCU_K$) defining the extent of said section of the blade (2);
   b. at least one intermediate control point

   ($PCU_i$, $i \in \llbracket 2, K-1 \rrbracket$ ) positioned between the end points ($PCU_1$, $PCU_K$),

the parameterization being performed according to at least one deformation parameter and said height of the section in the blade (2), as a function of which the abscissa of said at least one intermediate control point ($PCU_i$) and the ordinate of the second end point ($PCU_K$) are expressed, the deformation parameters being a relative height of the beginning of the deformation $h_0$ and a maximum offset $d_{max}$ at the end of the blade (2), the at least one parameterized Bezier curve being associated with a relative sectional height $h$ in the blade (2), h $\in$ [$h_0$, 1] ;
   - a module for determining optimized values of the deformation parameters, for which the intensity of a marginal vortex generated by the blade (2) is a minimum;
   - a module for outputting to an interface (13) of said piece of equipment (10) determined values.

11. A computer program product comprising code instructions for executing a method according to one of claims 1 to 8 for modeling at least one portion of a blade (2) of a non-streamlined propeller (1), when said program is executed on a computer.

12. A piece of computer equipment-readable storage means on which a computer program product comprises code instructions for executing a method according to one of claims 1 to 8 for modeling at least one portion of a blade (2) of a non-streamlined propeller (1).

FIG. 1

FIG. 2a

FIG. 2b

FIG. 3

FIG. 4

FIG. 5

FIG. 6a

FIG. 6b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **B. G. MARINUS.** Aerodynamic study of a 'humpy' propeller. *International Journal of Engineering Systems Modelling and Simulation,* 2012, vol. 4 (1/2), 27-35

- **C. DE MAESSCHALCK.** Blade Tip Shape Optimization for Enhanced Turbine Aerothermal Performance. *ASME Turbo Expo 2013: Turbine Technical Conférence and Exposition, Volume 3C: Heat Transfer. Paper No. GT2013-94754,* 03 Juin 2013, vol. 3C